# EUROPEAN PATENT APPLICATION

(11) **EP 3 101 700 A1**
(43) Date of publication of application: **07.12.2016**
(21) Application number: 15743871.4
(22) Date of filing: 07.01.2015
(51) Int. Cl.: H01L 33/62, H01L 33/50

(54) **LIGHT-EMITTING DEVICE**

(30) Priority: 29.01.2014 JP 2014014234; 31.03.2014 JP 2014072338; 08.08.2014 JP 2014162407
(71) Applicant: Sharp Kabushiki Kaisha, Sakai-shi Osaka 590-8522 (JP)
(72) Inventor: KANEKO, Nobumasa, Osaka 590-8522 (JP); NADA, Tomokazu, Osaka 590-8522 (JP); AGATANI, Makoto, Osaka 590-8522 (JP); HATA, Toshio, Osaka 590-8522 (JP); JINUSHI, Osamu, Osaka 590-8522 (JP); SOTA, Yoshiki, Osaka 590-8522 (JP); DEVISETTI, Naveen Venkata Rama, Osaka 590-8522 (JP); KANEKO, Kazuaki, Osaka 590-8522 (JP); ONUMA, Hiroaki, Osaka 590-8522 (JP)
(74) Representative: Treeby, Philip David William
(86) International application number: PCT/JP2015/050218
(87) International publication number: WO 2015/115134

(57) **Abstract**

Provided is a light-emitting device that is capable of adjusting color temperature through the supply of electric power from a single power supply. The light-emitting device includes an anode electrode land, a cathode electrode land, and first and second wires through which the anode electrode land and the cathode electrode land are connected to each other. The first wire is higher in electric resistance than the second wire. The color temperature of light that is emitted by a whole light-emitting unit including a first light-emitting unit electrically connected to the first wire and a second light-emitting unit electrically connected to the second wire is adjustable.

## Description

### Technical Field

The present invention relates to light-emitting devices and, in particular, to a light-emitting device that is capable of adjusting color temperature.

### Background Art

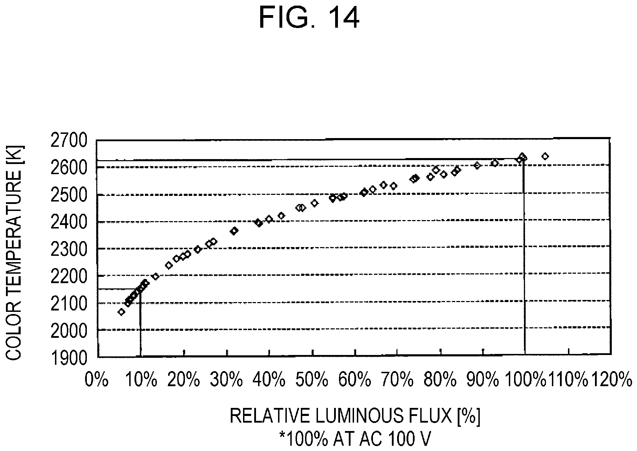

A halogen lamp is closely similar in energy distribution to a full radiator and therefore exhibits excellent color rendering properties. Furthermore, the halogen lamp is used as a visible light source, as the color temperature of light that is emitted by the halogen lamp can vary according to the magnitude of electric power that is supplied to the halogen lamp (see Fig. 14). However, since the halogen lamp emits infrared rays, it has presented problems such as becoming very high in temperature, requiring a reflecting plate for the prevention of infrared radiation, having a shorter life-span than an LED, and consuming a measurable amount of electric power. To address these problems, a white light-emitting device that generates less heat and includes a light-emitting diode with a longer operating life has been developed.

PTL 1 (Japanese Unexamined Patent Application Publication No. 2009-224656) discloses a light-emitting device including: a substrate having, on the bottom face, a recess formed with a plurality of slopes which are inclined in such a direction as to face each other; light-emitting elements installed on the slopes, respectively; and wavelength conversion members which are so provided as to cover the light-emitting elements, respectively, and convert lights emitted from the light-emitting elements into lights of different wavelengths.

PTL 2 (Japanese Unexamined Patent Application Publication No. 2011-159809) discloses a white light-emitting device including: a first white light generation system which includes an ultraviolet or violet LED chip and a phosphor and generates first white light, and a second white light generation system which includes a blue LED chip and a phosphor and generates second white light. The white light-emitting device is characterized in that the first and second white light generation systems are spatially separated, that the first white light has a lower color temperature than the second white light, and that mixed light including the first white light and second white light is emitted.

The technologies of PTLs 1 and 2 require a plurality of wiring patterns, as electric power is supplied from a different power supply to each light-emitting element. As such, the technologies of PTLs 1 and 2 have presented a problem of making the respective light-emitting devices complex in structure.

### Citation List

### Patent Literature

PTL 1: Japanese Unexamined Patent Application Publication No. 2009-224656
PTL 2: Japanese Unexamined Patent Application Publication No. 2011-159809

### Summary of Invention

### Technical Problem

The present invention, made in order to solve the foregoing problems, has as an object to provide a light-emitting device that is capable of adjusting color temperature through the supply of electric power from a single power supply.

### Solution to Problem

The present invention is directed to a light-emitting device including: an anode electrode land; a cathode electrode land; and first and second wires through which the anode electrode land and the cathode electrode land are connected to each other, wherein the first wire is higher in electric resistance than the second wire, and a color temperature of light that is emitted by a whole light-emitting unit including a first light-emitting unit electrically connected to the first wire and a second light-emitting unit electrically connected to the second wire is adjustable.

In the light-emitting device of the present invention, it is preferable that each of the first and second light-emitting units include an LED element, translucent resin, and at least two types of phosphors.

In the light-emitting device of the present invention, it is preferable that the first wire include a resistor.

In the light-emitting device of the present invention, it is preferable that the first and second light-emitting units be arranged so that lights respectively emitted by the first and second light-emitting units are mixed together.

In the light-emitting device of the present invention, it is preferable that the phosphors contained in the first light-emitting unit differ in content percentage from those contained in the second light-emitting unit.

In the light-emitting device of the present invention, it is preferable that the light-emitting device include a plurality of the first light-emitting units and a plurality of the second light-emitting units, that the plurality of first light-emitting units be connected in series on the first wire, that the plurality of second light-emitting units be connected in series on the second wire, and that each of the plurality of first and second light-emitting units include an LED element, translucent resin, and at least two types of phosphors.

The present invention is directed to a light-emitting device including: a substrate; an anode electrode land; a cathode electrode land; and first and second wires through which the anode electrode land and the cathode electrode land are connected to each other, the anode electrode land, the cathode electrode land, and the first and second wires being disposed on the substrate, wherein the first wire is higher in electric resistance than the second wire, a color temperature of light that is emitted by a whole light-emitting unit including a first light-emitting unit electrically connected to the first wire and a second light-emitting unit electrically connected to the second wire is adjustable, the light-emitting device further includes, on the substrate, a resin dam surrounding the whole light-emitting unit including the first and second light-emitting units, and either the first light-emitting unit or the second light-emitting unit covers at least part of the resin dam.

In the light-emitting device of the present invention, it is preferable that the light-emitting unit that covers the at least part of the resin dam be greater in height than the other light-emitting element.

### Advantageous Effects of Invention

The present invention makes it possible to obtain a light-emitting device that is capable of adjusting color temperature through the supply of electric power from a single power supply.

### Brief Description of Drawings

[Fig. 1] Fig. 1 is a plan view schematically showing a light-emitting device according to Embodiment 1 of the present invention.
[Fig. 2] Fig. 2 is a transparent view of the light-emitting device of Fig. 1.
[Fig. 3] Fig. 3 is a plan view schematically showing a light-emitting device according to Embodiment 2 of the present invention.
[Fig. 4] Fig. 4 is a transparent view of the light-emitting device of Fig. 3.
[Fig. 5] Fig. 5 is a cross-sectional view of the light-emitting device of Fig. 3 as taken along the line A-A.
[Fig. 6] Fig. 6(a) is a graph showing a relationship between the relative luminous flux and color temperature of light that is emitted by a light-emitting device. Fig. 6(b) is a diagram showing the spectra of lights that are emitted by the light-emitting device.
[Fig. 7] Fig. 7 is a plan view schematically showing a light-emitting device according to Embodiment 3 of the present invention.
[Fig. 8] Fig. 8 is a transparent view of the light-emitting device of Fig. 7.
[Fig. 9] Fig. 9 is a plan view schematically showing a light-emitting device according to Embodiment 4 of the present invention.
[Fig. 10] Fig. 10 is a transparent view of the light-emitting device of Fig. 9.
[Fig. 11] Fig. 11 is a transparent view of a modification of the light-emitting device according to Embodiment 4 of the present invention.
[Fig. 12] Fig. 12 is a plan view schematically showing a light-emitting device according to Embodiment 5 of the present invention.
[Fig. 13] Fig. 13 is a transparent view of the light-emitting device of Fig. 12.
[Fig. 14] Fig. 14 is a graph showing a relationship between the relative luminous flux and color temperature of light that is emitted by a halogen lamp.
[Fig. 15] Fig. 15 is a plan view schematically showing a light-emitting device according to Embodiment 6 of the present invention.
[Fig. 16] Fig. 16 is a transparent view of the light-emitting device of Fig. 15.
[Fig. 17] Fig. 17 is a plan view of a modification of the light-emitting device according to Embodiment 6 of the present invention.
[Fig. 18] Fig. 18 is a transparent view of the light-emitting device of Fig. 17.
[Fig. 19] Fig. 19 is a schematic view showing an example of a reflector.
[Fig. 20] Fig. 20 is a plan view schematically showing a light-emitting device according to Embodiment 7 of the present invention.
[Fig. 21] Fig. 21 is a transparent plan view of a light-emitting device according to Embodiment 8 of the present invention.
[Fig. 22] Fig. 22 is a plan view schematically showing a light-emitting device according to Embodiment 9 of the present invention.
[Fig. 23] Fig. 23 is a schematic view showing an example of a variable resistor.
[Fig. 24] Fig. 24 is a diagram showing, in Example 5, a chromaticity distribution of lights that are emitted by each separate light-emitting device as a whole in a low current range (100 mA) or a high current range (700 mA) in a case where the wires of the first light-emitting units of each separate light-emitting device are connected to a 30 Ω wiring pattern.
[Fig. 25] Fig. 25 is a diagram showing, in Example 5, a chromaticity distribution of lights that are emitted by each separate light-emitting device as a whole in a low current range (100 mA) or a high current range (700 mA) in a case where the wires of the first light-emitting units of each separate light-emitting device are connected to a wiring pattern having a different value of resistance. Description of Embodiments

Light-emitting devices of the present invention will be described below with reference to the drawings. It should be noted that, in the drawings of the present invention, the same reference signs represent the same parts or corresponding parts. Further, relationships between dimensions such as lengths, widths, thicknesses, and depths are changed as appropriate for clarification and simplification of the drawings, and as such, they are not intended to represent actual dimensional relationships.

### [Embodiment 1]

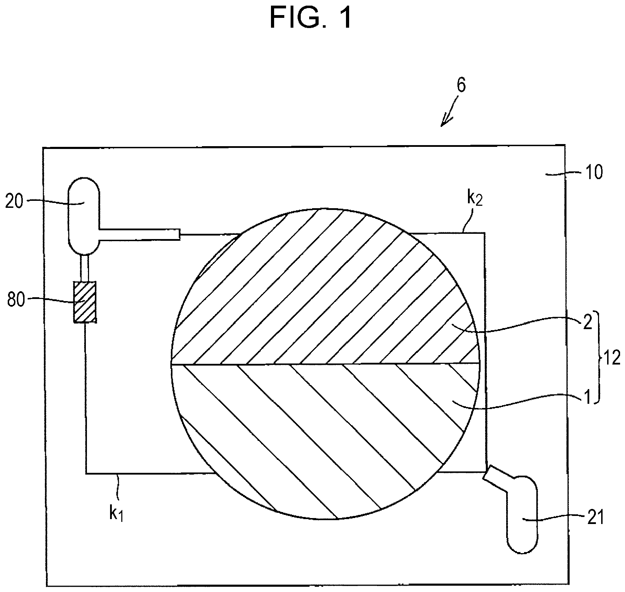

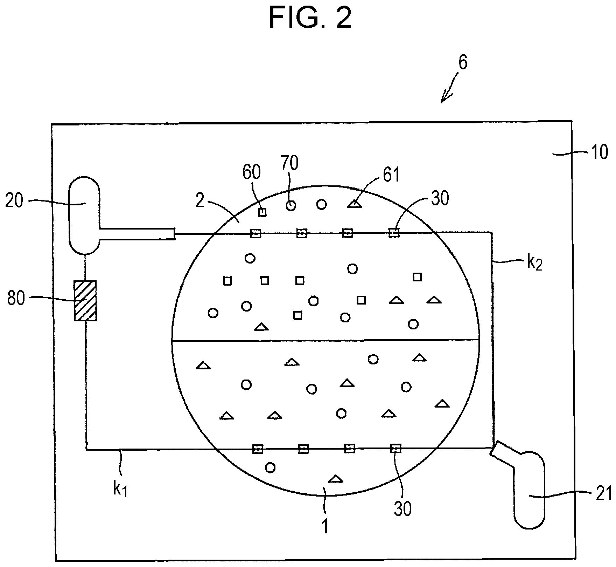

Fig. 1 is a plan view schematically showing a light-emitting device according to Embodiment 1 of the present invention. Fig. 2 is a transparent view of Fig. 1.

As shown in Fig. 1, a light-emitting device 6 includes an anode electrode land 21, a cathode electrode land 20, and first and second wires k1 and k2 through which the anode electrode land 21 and the cathode electrode land 20 are connected to each other. The anode electrode land 21, the cathode electrode land 20, and the first and second wires k1 and k2 are disposed on a substrate 10. The first wire is higher in electric resistance than the second wire. A light-emitting unit 12 includes a first light-emitting unit 1 electrically connected to the first wire and a second light-emitting unit 2 electrically connected to the second wire. A resistor 80 is connected to the first wire k1. The color temperature of light that is emitted by the whole light-emitting unit 12 including the first and second light-emitting units is adjustable.

As shown in Fig. 2, the first light-emitting unit 1 includes a second red phosphor 61, a green phosphor 70, LED elements 30, and translucent resin, and the second light-emitting unit 2 includes a first red phosphor 60, the second red phosphor 61, the green phosphor 70, LED elements 30, and the translucent resin. The anode electrode land 21, the plurality of LED elements 30, and the cathode electrode land 20 are electrically connected to one another through the wires.

The first and second light-emitting units 1 and 2 of the light-emitting device 6 emit lights through the supply of electric power from a single power supply. The light emitted by the first light-emitting unit 1 and the light emitted by the second light-emitting unit 2 are mixed together to be emitted as light from the light-emitting device 3 to the outside.

A change in the ratio of a current flowing to the first light-emitting unit 1 to a current flowing to the second light-emitting unit 2 does not lead to a change in the color temperatures of the lights emitted by the first and second light-emitting units 1 and 2, but leads to a change in the ratio of the luminous flux of the light emitted by the first light-emitting unit 1 to the luminous flux of the light emitted by the second light-emitting unit 2. Therefore, the color temperature of the light from the whole light-emitting unit 12, i.e. the mixture of the lights emitted by the first and second light-emitting units 1 and 2, can be changed.

### (Anode Electrode Land, Cathode Electrode Land, First Wire, Second Wire, and Substrate)

The first and second wires are arranged parallel to each other so that the anode electrode land and the cathode electrode land are connected to each other through the first and second wires. The first and second wires are formed on the substrate by a screen printing method or the like. A protection element may be connected to at least either the first wire or the second wire.

The electrode lands are electrodes for use in external connection (e.g. power supply), are made of Ag-Pt or the like, and are formed by a screen printing method or the like.

### (Red Phosphors)

Each of the red phosphors radiates light having a peak emission wavelength in a red region upon being excited by primary light radiated from the LED elements. The red phosphor emits no light in a wavelength range of not shorter than 700 nm and absorbs no light in a wavelength range of not shorter than 550 nm to not longer than 600 nm. Saying that "the red phosphor emits no light in a wavelength range of not shorter than 700 nm" means that the emission intensity of the red phosphor in the wavelength range of not shorter than 700 nm at a color temperature of not lower than 300 K is not more than 1/100 times as high as the emission intensity of the red phosphor at the peak emission wavelength. Saying that "the red phosphor absorbs no light in a wavelength range of not shorter than 550 nm to not longer than 600 nm" means that an integrated value of portions of the excitation spectrum of the red phosphor in the wavelength range of not shorter than 550 nm to not longer than 600 nm is not more than 1/100 times as large as an integrated value of portions of the excitation spectrum of the red phosphor in a wavelength range of not shorter than 430 nm to not longer than 480 nm. It should be noted that the excitation spectrum is measured at the peak wavelength of the red phosphor. The term "red region" as used herein means a wavelength region of not shorter than 580 nm to shorter than 700 nm.

Emission of light from the red phosphor can hardly be seen in a long-wavelength region of not shorter than 700 nm. In the long-wavelength region of not shorter than 700 nm, a human has a relatively small luminosity factor. Therefore, in a case where the light-emitting device is used, for example, for illumination purpose or the like, the use of the red phosphor provides a major advantage.

Further, the red phosphor hardly absorbs secondary light from the green phosphor, as the red phosphor absorbs no light in the wavelength range of not shorter than 550 nm to not longer than 600 nm. This makes it possible to prevent the occurrence of two-stage light emission in which the red phosphor emits light by absorbing the secondary light from the green phosphor. This in turn keeps high light emission efficiency.

The red phosphor may be any phosphor that is used in a wavelength conversion unit of a light-emitting device. For example, the red phosphor may be a (Sr, Ca)AlSiN₃:Eu phosphor, a CaAlSiN₃:Eu phosphor, or the like.

### (Green Phosphor)

The green phosphor radiates light having a peak emission wavelength in a green region upon being excited by the primary light radiated from the LED elements. The green phosphor may be any phosphor that is used in a wavelength conversion unit of a light-emitting device. For example, the green phosphor may be a phosphor represented by general formula (1): (M1)₃₋ₓCeₓ (M2)₅O₁₂ (where (M1) is at least one of Y, Lu, Gd, and La, (M2) is at least one of Al and Ga, and x is the composition ratio of Ce and satisfies 0.005 ≤ x ≤ 0.20) or the like. The term "green region" means a wavelength region of not shorter than 500 nm to not longer than 580 nm.

In a case where one type of green phosphor is used (e.g. for general illumination purpose or the like), it is preferable that the half-width of the fluorescence spectrum of the green phosphor be wide, e.g. 95 nm or wider. A phosphor with Ce added thereto as an activator, e.g. a Lu₃₋ₓCeₓAl₅O₁₂ green phosphor, has a garnet crystal structure. This phosphor gives a fluorescent spectrum with a wide half-width (of 95 nm or wider), as Ce is used as an activator. Therefore, a phosphor with Ce added thereto as an activator serves as a suitable green phosphor for achieving high color rendering properties.

### (LED Elements)

The LED elements radiate light having a peak emission wavelength in the wavelength range of not shorter than 430 nm to not longer than 480 nm. Use of light-emitting elements whose peak emission wavelengths are shorter than 430 nm leads to a decline in the contribution ratio of a component of blue light to the light from the light-emitting device, and may therefore invite deterioration in color rendering properties and, by extension, a decrease in practicality of the light-emitting device. Use of LED elements whose peak emission wavelengths are longer than 480 nm may invite a decrease in practicality of the light-emitting device. In particular, use of InGaN LED elements leads to a decline in quantum efficiency and therefore invites a pronounced decrease in practicality of the light-emitting device.

It is preferable that the LED elements be LED elements that radiate light including light of a blue component having a peak emission wavelength in a blue region (i.e. the wavelength region of not shorter than 430 nm to not longer than 480 nm), and it is more preferable that the LED elements be InGaN LED elements. Possible examples of the LED elements are LED elements having peak emission wavelengths in the neighborhood of 450 nm. The term "InGaN LED elements" here means LED elements whose light-emitting layers are InGaN layers.

Each of the LED elements has a structure in which light is radiated from an upper surface thereof. Further, each of the LED elements has, on a surface thereof, electrode pads (not illustrated; for example, an anode electrode pad and a cathode electrode pad) for, via the wires, connecting the LED element to adjacent LED elements and connecting the LED element to a wiring pattern.

### (First and Second Light-emitting Units)

Each of the first and second light-emitting units (hereinafter also referred to collectively as "light-emitting unit", including both) includes the transparent resin and the green and red phosphors uniformly dispersed in the translucent resin.

In Fig. 1, the first and second light-emitting units are disposed within the same circle. The circle is divided into two parts, namely first and second sections, by a straight light passing through the center of the circle. The first and second light-emitting units 1 and 2 are disposed in the first and second sections, respectively. In Fig. 1, the first and second light-emitting units 1 and 2 are adjacent to each other at a boundary line. This makes it easy to mix together the lights respectively emitted by the first and second light-emitting units 1 and 2, thus allowing the whole light-emitting unit 12 to emit light at a more uniform color temperature. It should be noted that although it is preferable that the first and second light-emitting units 1 and 2 be arranged next to each other, the first and second light-emitting units do not necessarily be in contact with each other, provided the lights respectively emitted by the first and second light-emitting units can be mixed together. In this case, it is preferable that the first and second light-emitting units be disposed at such a short distance from each other that the lights emitted by the respective light-emitting units can be fully mixed together.

The shape of the whole light-emitting unit including the first and second light-emitting units is not limited to such a circle as that shown in Fig. 1, provided the shape allows the lights respectively emitted by the first and second light-emitting units 1 and 2 to be mixed together. For example, the shape of the whole light-emitting unit may be any shape such as a substantially rectangular shape, a substantially elliptical shape, or a polygonal shape. The respective shapes of the first and second light-emitting units disposed within the whole light-emitting unit are not limited to particular shapes, either. For example, it is preferable that the first and second light-emitting units be so shaped as to have equal surface areas. Such shapes can be obtained by dividing the whole light-emitting unit into two parts, namely first and second sections, by a line passing through the center of the whole light-emitting unit and disposing the first and second light-emitting units in the first and second sections, respectively. It should be noted that the first and second light-emitting units may have different surface areas, provided the color temperatures of the lights respectively emitted by the first and second light-emitting units are adjustable. Although it is preferable that the first and second light-emitting units be arranged next to each other, the first and second light-emitting units do not necessarily be in contact with each other, provided the lights respectively emitted by the first and second light-emitting units can be mixed together.

The arrangement of the first and second light-emitting units is not limited to particular arrangements, provided the lights respectively emitted by the first and second light-emitting units can be mixed together. For example, the first light-emitting unit may be formed into a circular shape, and the second light-emitting unit may be disposed in such a doughnut shape as to surround the first light-emitting unit. This makes it easy to mix together the lights respectively emitted by the first and second light-emitting units 1 and 2, thus allowing the whole light-emitting unit to emit light at a more uniform color temperature. Although it is preferable that the first and second light-emitting units be arranged next to each other, the first and second light-emitting units do not necessarily be in contact with each other, provided the lights respectively emitted by the first and second light-emitting units can be mixed together.

In the light-emitting unit, a portion of the primary light (e.g. blue light) radiated from the LED elements is converted into green light and red light. Therefore, the light-emitting device according to Embodiment 1 emits mixed light including the primary light, the green light, and the red light or, preferably, white light. It should be noted that the mixing ratio of the green phosphor to the red phosphors is not limited to particular values, and it is preferable that the mixing ratio be set so that a desired property can be achieved.

The translucent resin contained in the light-emitting unit is not limited, provided the resin has translucency. For example, it is preferable that the resin be epoxy resin, silicone resin, urea resin, or the like. It should be noted that the light-emitting unit may include an additive such as SiO₂, TiO₂, ZrO₂, Al₂O₃, or Y₂O₃ in addition to the translucent resin, the green phosphor, and the red phosphors. By including such an additive, the light-emitting unit can bring about an effect of preventing the sedimentation of phosphors such as the green phosphor and the red phosphors or an effect of efficiently diffusing light from the LED elements, the green phosphor, and the red phosphors.

The luminous flux of the light emitted by the first light-emitting unit and the luminous flux of the light emitted by the second light-emitting unit can be adjusted by changing the magnitude of currents respectively flowing through the first and second wires.

In the case of a rated current value, it is preferable that the color temperature (hereinafter also referred to as "Tcₘₐₓ") of the light emitted by the whole light-emitting unit, i.e. the mixture of the lights emitted by the first and second light-emitting units, be 2700 K to 6500 K. When the magnitude of the currents is made smaller than the rated current value, the lights emitted by the first and second light-emitting units become smaller in luminous flux, and the light emitted by the whole light-emitting unit becomes smaller in luminous flux, whereby the color temperature drops. From the point of view of achieving a wide color temperature range, it is preferable that, assuming that the luminous flux of the light emitted by the whole light-emitting unit is 100% in the case of the rated current value, the color temperature of the light emitted by the whole light-emitting unit be lower than Tcₘₐₓ by not less than 300 K when the luminous flux of the light emitted by the whole light-emitting unit has been changed to 20% by making the magnitude of the currents smaller.

### (Resistor)

The resistor is serially connected to the first wire. The magnitude of the currents flowing through the first and second wires can be adjusted by changing the size of the resistor. As the magnitude of the currents flowing through the first and second wires changes, the luminous flux of light emitted by the LED elements connected to the first or second wire changes, and the luminous flux of the lights emitted by the first and second light-emitting units changes, too. The color temperature of the light emitted by the whole light-emitting element can be adjusted by changing the size of the resistor, as a change in the luminous flux of the light emitted by the light-emitting unit leads to a change in the color temperature of the light.

The resistor may be a chip resistor or a printed resistor.

In Embodiment 1, the resistor is only connected to the first wire. In addition, a resistor may be connected to the second wire. In this case, the resistors are chosen to be connected to the first and second wires, respectively, so that the first wire has a larger value of resistance than the second wire.

### [Embodiment 2]

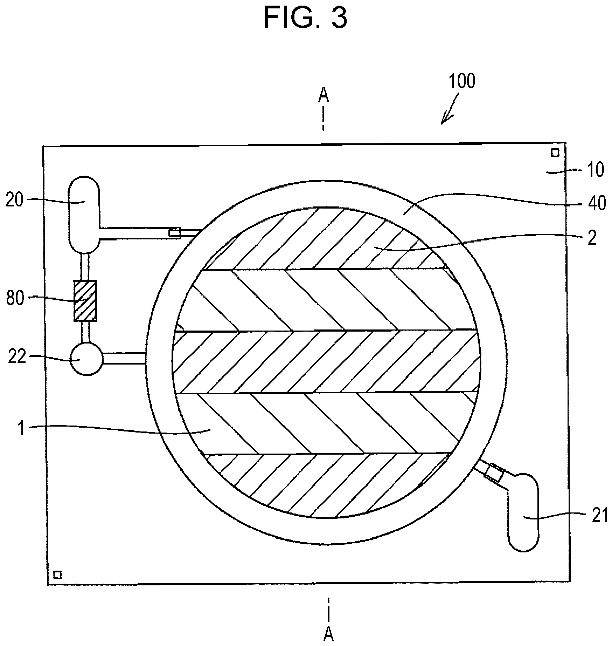

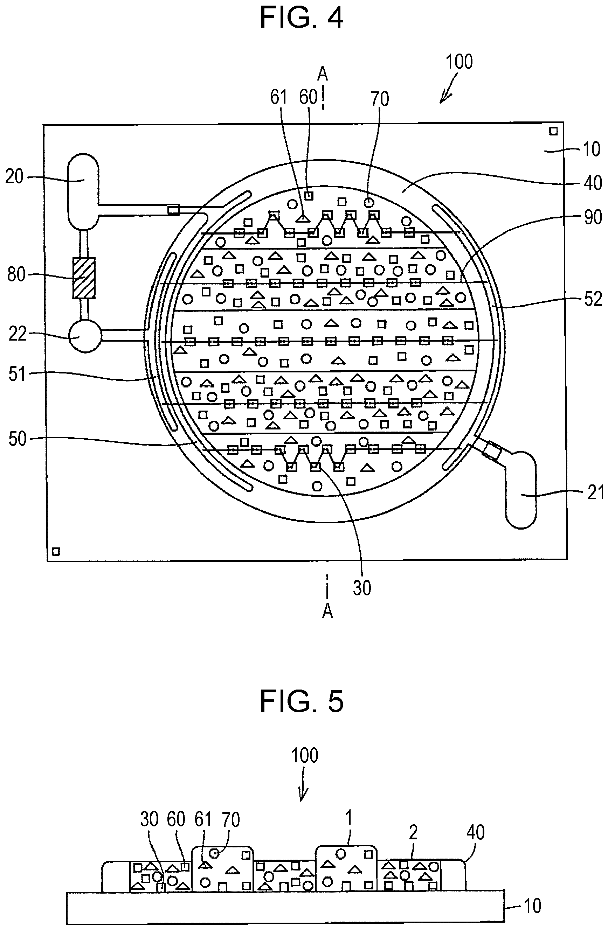

Fig. 3 is a plan view schematically showing a light-emitting device according to Embodiment 2 of the present invention. Fig. 4 is a transparent view of the light-emitting device of Fig. 3. Fig. 5 is a cross-sectional view of the light-emitting device of Fig. 3 as taken along the line A-A.

The light-emitting device according to Embodiment 2 includes basic components that are identical to those which the light-emitting device according to Embodiment 1 includes. The light-emitting device according to Embodiment 2 differs from the light-emitting device according to Embodiment 1 in that the light-emitting device according to Embodiment 2 includes two first light-emitting units 1 and three light-emitting units 2, that the light-emitting device according to Embodiment 2 includes a resin dam 40 disposed around the light-emitting unit, that a resistance value monitoring land 22 is connected to the first wire, and that wires 90 are connected to the electrode lands via wiring patterns 50, 51, and 52.

The first wire is electrically connected to each of the two first light-emitting units 1, and the two first light-emitting units 1 are arranged parallel to each other on the first wire. The second wire is electrically connected to each of the three second light-emitting units 2, and the three second light-emitting units 2 are arranged parallel to one another on the second wire. Increasing the numbers of first and second light-emitting units 1 and 2 and arranging them alternately in contact with each other makes it easy to mix together the light emitted from the first light-emitting units 1 and the light emitted from the second light-emitting units 2, thus allowing the light-emitting device to emit light at a more uniform color temperature. It should be noted that although it is preferable that the first and second light-emitting units 1 and 2 be arranged next to each other, the first and second light-emitting units do not necessarily be in contact with each other, provided the lights respectively emitted by the first and second light-emitting units can be mixed together. In this case, it is preferable that the first and second light-emitting units be disposed at such a short distance from each other that the lights emitted by the respective light-emitting units can be fully mixed together.

The arrangement of the first and second light-emitting units is not limited to particular arrangements, provided the lights respectively emitted by the first and second light-emitting units can be mixed together. For example, the whole light-emitting unit used in the light-emitting device may be one that includes a side-by-side arrangement of first and second light-emitting units obtained by repeating the step of forming a first light-emitting unit into a circular shape, then forming a second light-emitting unit into a doughnut shape so that the second light-emitting unit surrounds the first light-emitting unit, and further forming a first light-emitting unit into a doughnut shape so that the first light-emitting unit surrounds the second light-emitting unit.

The resistor 80 and the resistance value monitoring land 22 are electrically connected to each other and disposed between the cathode electrode land 20 and a first light-emitting unit 1. Since the resistor 80 is a chip resistor, is apart from the cathode electrode land and the resistance value monitoring land, and brings about no obstacles to soldering, the resistor 80 can be easily soldered. It is preferable that the resistor 80 be covered with phosphor-containing resin or colored resin.

### (Resin Dam)

The resin dam is resin for damming up the first and second light-emitting units, which includes the translucent resin. It is preferable that the resin dam be made of a colored material (which may be a white, milky-white, red, yellow, or green colored material that absorbs less light). For reduction of absorption of light radiated from the LED elements or light converted by the phosphors, it is preferable that the resin dam be so formed as to cover the wiring patterns.

### (First and Second Light-emitting Units)

In Fig. 5, the first and second light-emitting units 1 and 2 are disposed in an area surrounded by the resin dam 40. The first and second light-emitting units 1 and 2 can be formed according to the following method. The green phosphor and the red phosphors are uniformly mixed into the translucent resin. The mixed resin thus obtained is injected into the area surrounded by the resin dam, and is then subjected to heat treatment. This heat treatment causes the translucent resin to be cured, whereby the green phosphor and the red phosphors become sealed.

It is preferable that the first light-emitting units 1 be higher in thixotropy than the second light-emitting units 2. When the first light-emitting units 1 are higher in thixotropy than the second light-emitting units 2, the first light-emitting units 1 have their surfaces at a higher level than the second light-emitting units 2 as shown in Fig. 5. This allows the first light-emitting units 1 to serve as resin dams for the second light-emitting units 2. Furthermore, when the first light-emitting units 1 are higher in thixotropy than the second light-emitting units 2, the mixing of the phosphors and the like contained in one light-emitting unit with or into those contained in another light-emitting unit can be reduced.

### [Embodiment 3]

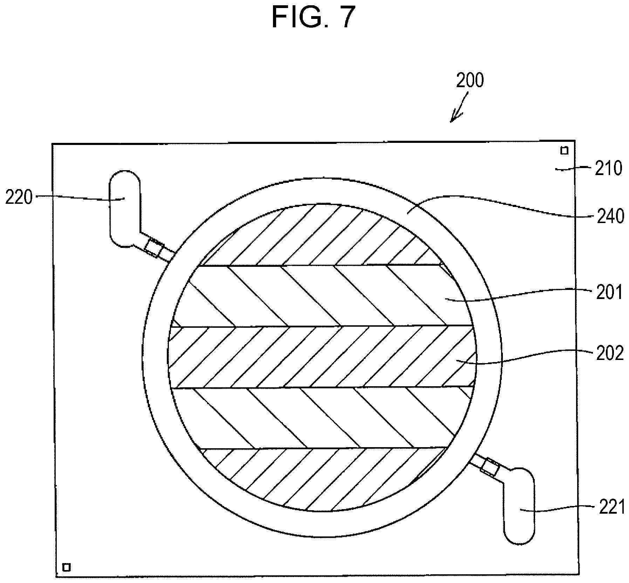

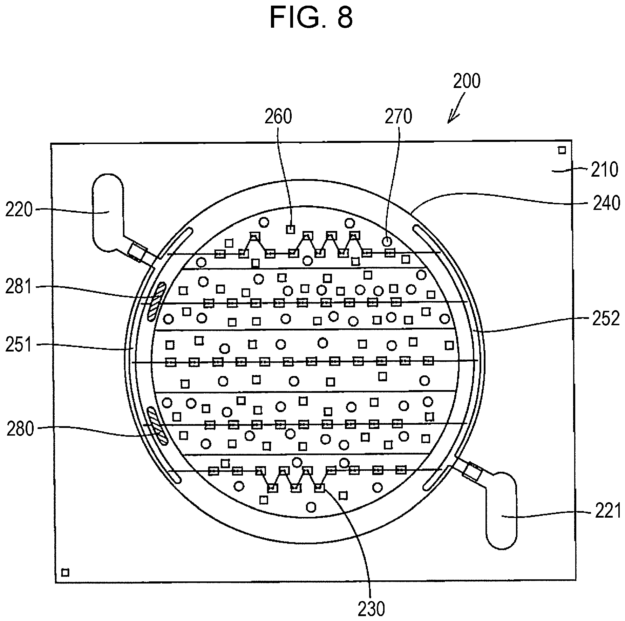

Fig. 7 is a plan view schematically showing a light-emitting device according to Embodiment 3 of the present invention. Fig. 8 is a transparent view of the light-emitting device of Fig. 7.

The light-emitting device according to Embodiment 3 includes basic components that are identical to those which the light-emitting device according to Embodiment 2 includes. The light-emitting device according to Embodiment 3 differs from the light-emitting device according to Embodiment 2 in that resistors 280 and 281 are disposed between a wiring pattern 251 and first light-emitting units 201, respectively, that the resistors 280 and 281 are covered with a resin dam 240, that the first light-emitting units 201 and second light-emitting units 202 are electrically connected to the same wiring pattern 251, and that no resistance value monitoring land is provided. Covering at least part of each of the resistors with the resin dam allows less light to be absorbed by the resistors, thus improving the light emission efficiency of the light-emitting device. It is preferable that the resistors and the wiring patterns be entirely covered with the resin dam.

### [Embodiment 4]

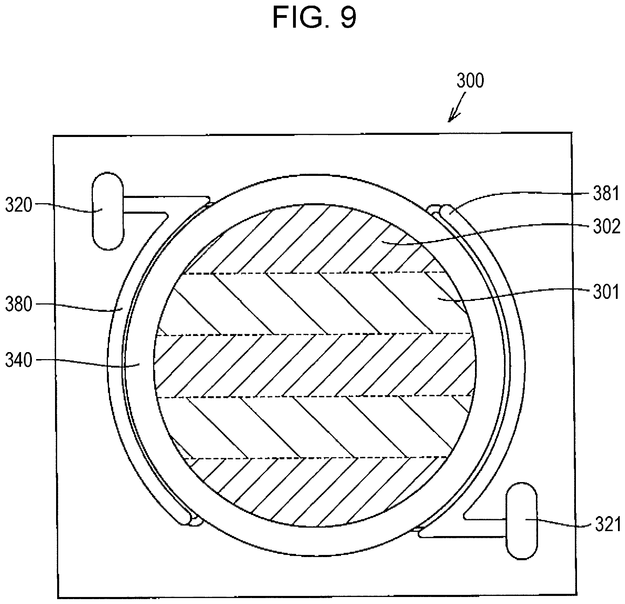

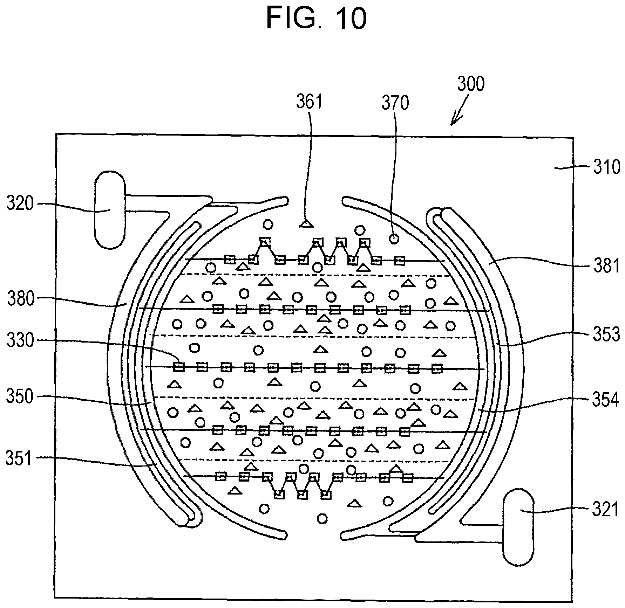

Fig. 9 is a plan view schematically showing a light-emitting device according to Embodiment 4 of the present invention. Fig. 10 is a transparent view of the light-emitting device of Fig. 9.

The light-emitting device according to Embodiment 4 includes basic components that are identical to those which the light-emitting device according to Embodiment 2 includes. The light-emitting device according to Embodiment 4 differs from the light-emitting device according to Embodiment 2 in that an anode electrode land 321, a resistor 381, and a wiring pattern 353 are electrically connected to one another, that a resistor 380 and the resistor 381 are printed resistors and are not covered with a resin dam 340, that first light-emitting units 301 are electrically connected to the wiring pattern 353 and second light-emitting units 302 are electrically connected to a wiring pattern 354, and that no resistance value monitoring land is provided. For easier manufacturing, it is preferable that the resistors be printed resistors. Making the resistors 380 and 381 lower in height than the resin dam 340 allows less light to be absorbed by the resistors, thus improving the light emission efficiency of the light-emitting device.

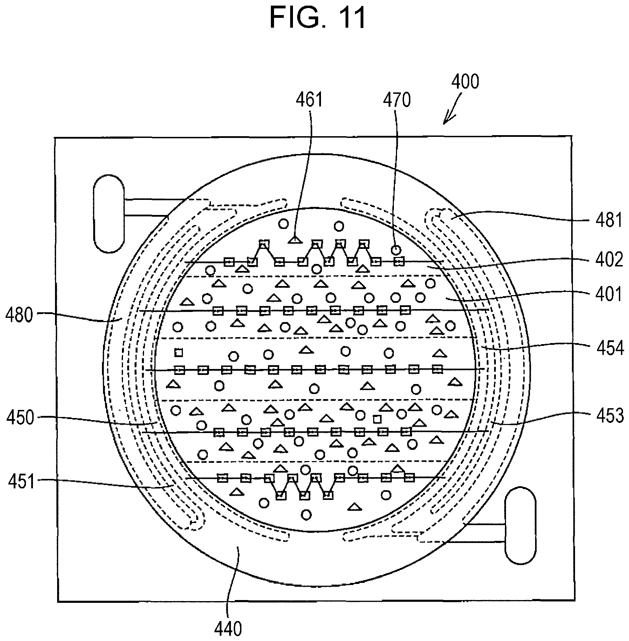

Fig. 11 is a transparent view of a modification of the light-emitting device according to Embodiment 4 of the present invention. In this modification, resistors 480 and 481 are partially covered with a resin dam 440, and wiring patterns 450, 451, 453, and 454 are entirely covered with the resin dam 440. Covering the resistors and the wiring patterns with the resin dam 440 allows less light to be absorbed by the resistors, thus improving the light emission efficiency of the light-emitting device. It is preferable that the resistors and the wiring patterns be entirely covered with the resin dam 440.

### [Embodiment 5]

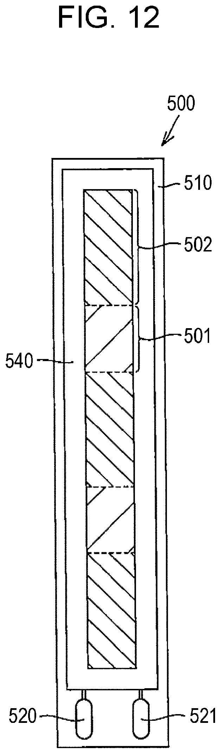

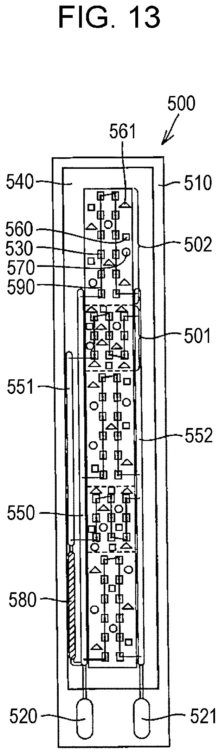

Fig. 12 is a plan view schematically showing a light-emitting device according to Embodiment 5 of the present invention. Fig. 13 is a transparent view of the light-emitting device of Fig. 12.

The light-emitting device according to Embodiment 5 includes basic components that are identical to those which the light-emitting device according to Embodiment 2 includes. The light-emitting device according to Embodiment 5 differs from the light-emitting device according to Embodiment 2 in that the whole light-emitting unit, which is formed by first and second light-emitting units 501 and 502, is in the shape of a rectangle when the light-emitting device is viewed from above, that a resistor 580 is a printed resistor and is covered with a resin dam 540, and that no resistance value monitoring land is provided. Covering the resistor with the resin dam 540 allows less light to be absorbed by the resistor, thus improving the light emission efficiency of the light-emitting device. It is preferable that the resistor and the wiring patterns be entirely covered with the resin dam 540. In Fig. 12, the first and second light-emitting units 501 and 502 are each in the shape of a rectangle, and have their shorter sides in contact with each other. Alternatively, the first and second light-emitting units 501 and 502 may have their longer sides in contact with each other.

### [Embodiment 6]

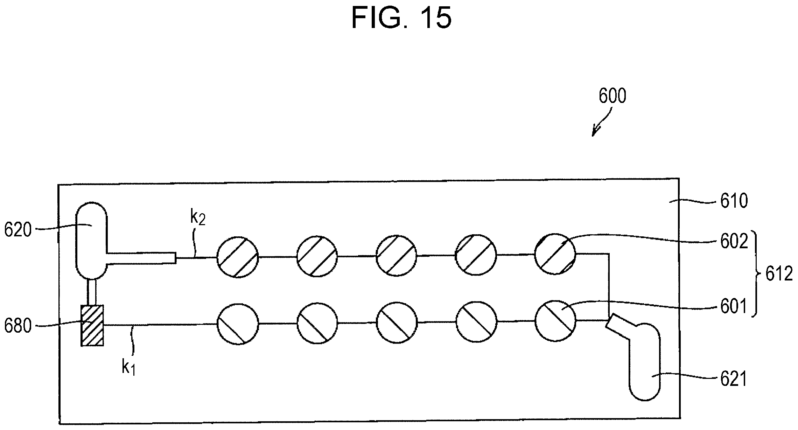

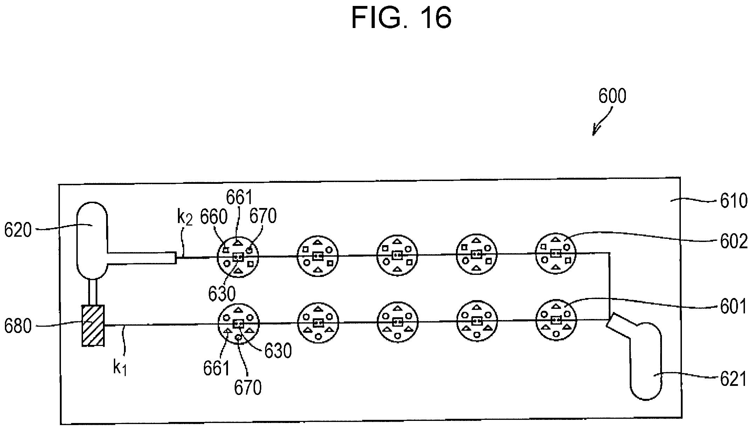

Fig. 15 is a plan view schematically showing a light-emitting device according to Embodiment 6 of the present invention. Fig. 16 is a transparent view of the light-emitting device of Fig. 15.

The light-emitting device according to Embodiment 6 includes basic components that are identical to those which the light-emitting device according to Embodiment 1 includes. The light-emitting device according to Embodiment 6 differs from the light-emitting device according to Embodiment 1 in that five first light-emitting units 601 are connected in series on the first wire k1, that five second light-emitting units 602 are connected in series on the second wire k2, and that the first and second light-emitting units are not adjacent to each other and are disposed at such a short distance from each other that the lights emitted by the respective light-emitting units can be fully mixed together.

Specifically, as shown in Fig. 15, a light-emitting device 600 includes an anode electrode land 621, a cathode electrode land 620, and the first and second wires k1 and k2 through which the anode electrode land 621 and the cathode electrode land 620 are connected to each other. The anode electrode land 621, the cathode electrode land 620, and the first and second wires k1 and k2 are disposed on a substrate 610. The first wire is higher in electric resistance than the second wire. A light-emitting unit 612 includes the five first light-emitting units 601 electrically connected in series on the first wire k1 and the five second light-emitting unit 602 electrically connected in series on the second wire k2. A resistor 680 is connected to the first wire k1. Since the first and second light-emitting units 601 and 602 are disposed at such a short distance from each other that the lights emitted by the respective light-emitting units can be fully mixed together, the whole light-emitting device emits light at a more uniform color temperature. It is preferable that the distance between the first and second light-emitting units be such that the shortest distance between the respective outer edges of the light-emitting units is 28 mm or shorter or, more preferably, 22 mm or shorter. When the distance between the first and second light-emitting units is 28 mm or shorter, the lights respectively emitted by the first and second light-emitting units can be fully mixed together.

As shown in Fig. 16, each of the plurality of first light-emitting units 601 includes a second red phosphor 661, a green phosphor 670, an LED element 630, and translucent resin, and each of the plurality of second light-emitting units 602 includes a first red phosphor 660, a second red phosphor 661, a green phosphor 670, an LED element 630, and translucent resin.

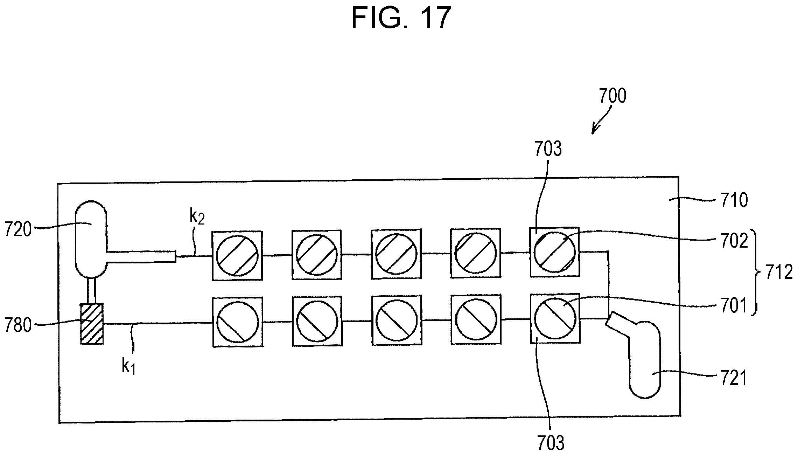

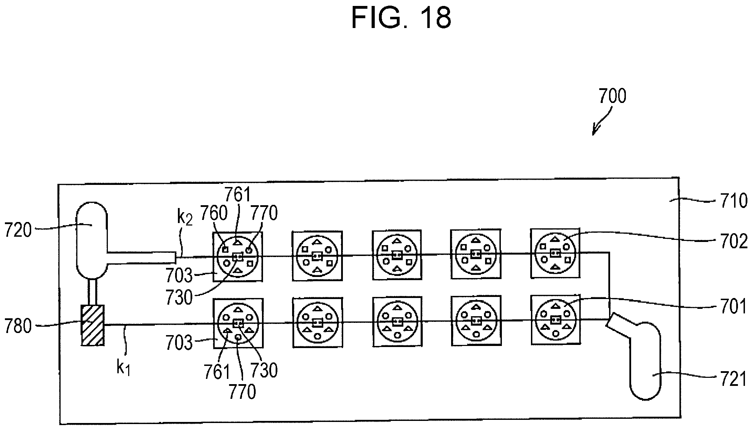

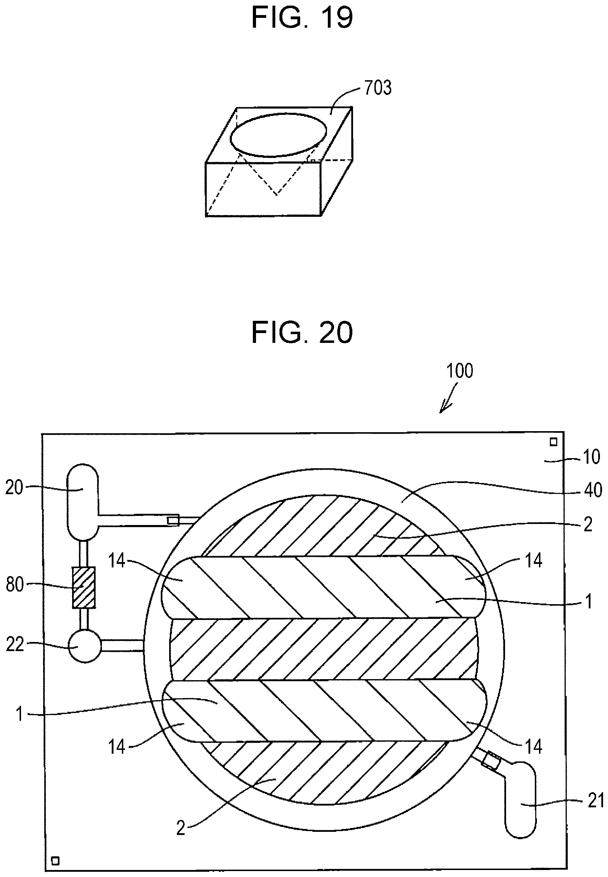

Fig. 17 is a plan view of a modification of the light-emitting device according to Embodiment 6 of the present invention. Fig. 18 is a transparent view of the light-emitting device of Fig. 17. In this modification, first and second light-emitting units 701 and 702 are disposed within reflectors 703, respectively. The shape of each of the reflectors 703 is not limited to particular shapes. For example, as shown in Fig. 19, the shape may be one formed by hollowing out the inside part of a rectangular parallelepiped into a conical shape. Alternatively, the reflectors may be replaced by walls that surround the first and second light-emitting units 701 and 702, respectively.

It is preferable that the distance between the first and second light-emitting units be such that the shortest distance between the respective outer edges of the light-emitting units is 28 mm or shorter or, more preferably, 22 mm or shorter. When the distance between the first and second light-emitting units is 28 mm or shorter, the lights respectively emitted by the first and second light-emitting units can be fully mixed together. It is preferable that each of the respective LED elements of the first and second light-emitting units have a beam angle of 140 degrees or smaller, more preferably, 120 degree or smaller. When each of the LED elements has a beam angle (value twice as large as the angle between a direction of luminous intensity half as high as the maximum luminous intensity of light exiting from the LED element and the optical axis) of 140 degrees or smaller, satisfactory brightness can be achieved.

### [Embodiment 7]

Fig. 20 is a plan view schematically showing a light-emitting device according to Embodiment 7 of the present invention.

The light-emitting device according to Embodiment 7 includes basic components that are identical to those which the light-emitting device according to Embodiment 2 includes. The light-emitting device according to Embodiment 7 differs from the light-emitting device according to Embodiment 2 in that the phosphor-containing translucent resin of the first light-emitting units partially covers the resin dam 40 disposed around the light-emitting unit.

A process of manufacturing the light-emitting device according to Embodiment 7 includes forming the resin dam 40, then forming the first light-emitting units 1 in the area surrounded by the resin dam 40, and forming the second light-emitting units 2 by injecting the phosphor-containing translucent resin, which constitutes the second light-emitting units 2, into regions surrounded by the resin dam 40 and the first light-emitting units 1. For example, under circumstances where it is desirable, for emission of light at low color temperature, that the first light-emitting units 1 be narrower in width, the first light-emitting units must be formed like a drawing of a resin layer. This causes the resin to dribble at longitudinal ends of the first light-emitting units 1, and the longitudinal ends 14 have such bulges as those shown in Fig. 20.

When the first light-emitting units 1 are formed in the area surrounded by the resin dam 40 so that the longitudinal ends 14 of the first light-emitting units 1 are located inside of parts surrounded by the resin dam 40, the subsequent injection of the second light-emitting units 2 causes the second light-emitting units 2 to surround the longitudinal ends 14 of the first light-emitting units. This disables the light emitted by the first light-emitting units 1 and the light emitted by the second light-emitting units 2 to be fully mixed together, thus disabling the whole light-emitting device to emit light at a desired color temperature.

On the other hand, when, as shown in Fig. 20, the longitudinal ends 14 of the first light-emitting units 1 are so formed as to partially cover the resin dam 40, the subsequent injection of the second light-emitting units 2 does not cause the longitudinal ends 14 of the first light-emitting units 1 to be surrounded by the second light-emitting units 2. This allows the light emitted by the first light-emitting units 1 and the light emitted by the second light-emitting units 2 to be fully mixed together, thus allowing the whole light-emitting device to emit light at the desired color temperature.

It is preferable that the longitudinal ends 14 of the first light-emitting units 1 be located closer to the outside than the center of the width of the resin dam 40. This allows the boundary lines between the first and second light-emitting units 1 and 2 to be in contact with the resin dam while being kept substantially straight. This in turn makes it possible to surely prevent the second light-emitting units 2 from surrounding the longitudinal ends 14 of the first light-emitting units 1.

It is preferable that the longitudinal ends 14 of the first light-emitting units 1 be formed on the resin dam 40. This makes it possible to prevent the first light-emitting units 1 from partially or entirely covering the resistor value monitoring land 22 or the resistor 80. Coverage of the resistor value monitoring land 22 with the first light-emitting units 1 makes it impossible to measure a value of resistance. Further, partial coverage of the resistor 80 with the first light-emitting units 1 makes it impossible to make a notch in the resistor 80 by laser trimming to adjust it so that a desired value of resistance can be achieved.

It is preferable that the first light-emitting units 1 be greater in height than the second light-emitting units 2. This makes it possible to prevent the second light-emitting units 2 from overriding the first light-emitting units 1 when the second light-emitting units 2 are injected after the resin dam 40 and the first light-emitting units 1 have been formed. This makes it possible to prevent and reduce the mixing together of the phosphors contained in the first light-emitting units 1 and the phosphors contained in the second light-emitting units 2.

In Embodiment 7, the light-emitting device includes two first light-emitting units 1 and three second light-emitting units 2. However, the numbers of first and second light-emitting units 1 and 2 are not limited to these numbers, but may each be 1 or larger.

### [Embodiment 8]

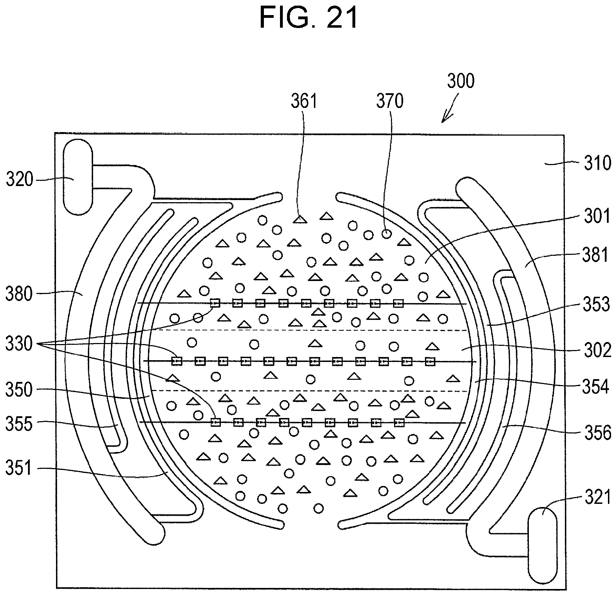

Fig. 21 is a transparent plan view of a light-emitting device according to Embodiment 8 of the present invention.

The light-emitting device according to Embodiment 8 includes basic components that are identical to those which the light-emitting device according to Embodiment 4 includes. The light-emitting device according to Embodiment 8 differs from the light-emitting device according to Embodiment 4 in that the light-emitting device according to Embodiment 8 includes two first light-emitting units and one second light-emitting unit, that two wiring patterns 351 and 355 are connected to the resistor 380, and that two wiring patterns, namely the wiring pattern 353 and a wiring pattern 356, are connected to the resistor 381. The wiring patterns 351 and 355 are connected to the resistor 380 at different places and therefore have different values of resistance. Similarly, the wiring patterns 353 and 356 are connected to the resistor 381 at different places and therefore have different values of resistance.

In Fig. 21, wires through which LED elements 330 of the first light-emitting units 301 are connected to one another are connected to the wiring patterns 351 and 354, and a wire through which LED elements 330 of the second light-emitting element are connected to one another is connected to a wiring pattern 350 and the wiring pattern 354. Alternatively, these wires may be connected to any of the wiring patterns 350, 351, 353, 354, 355, and 356.

Use of LED elements in light-emitting devices causes variations in chromaticity among the light-emitting devices, as forward voltage (VF) values vary from one LED element to another. This makes it necessary to, in order to achieve constant chromaticity, change the mixing ratio of the phosphors to the translucent resin in the light-emitting unit according to the VF values of the LED elements, thus making mixing condition management and chromaticity management cumbersome and complicated. Meanwhile, the chromaticity of a light-emitting device also changes according to the value of resistance of a wiring pattern to which LED elements are connected. This makes it possible to reduce the effect of the variations in VF value on the chromaticity of the light-emitting device by selecting, according to the VF value of the LED elements, the value of resistance of the wiring pattern to which the LED elements are connected. That is, while keeping the mixing ratio of the phosphors to the translucent resin, the light-emitting device according to Embodiment 8 makes it possible to achieve desired chromaticity by selecting, as the wiring pattern to which the LED elements are connected, a wiring pattern having an optimum value of resistance. Therefore, the light-emitting device according to Embodiment 8 can reduce variations in chromaticity among light-emitting devices.

### [Embodiment 9]

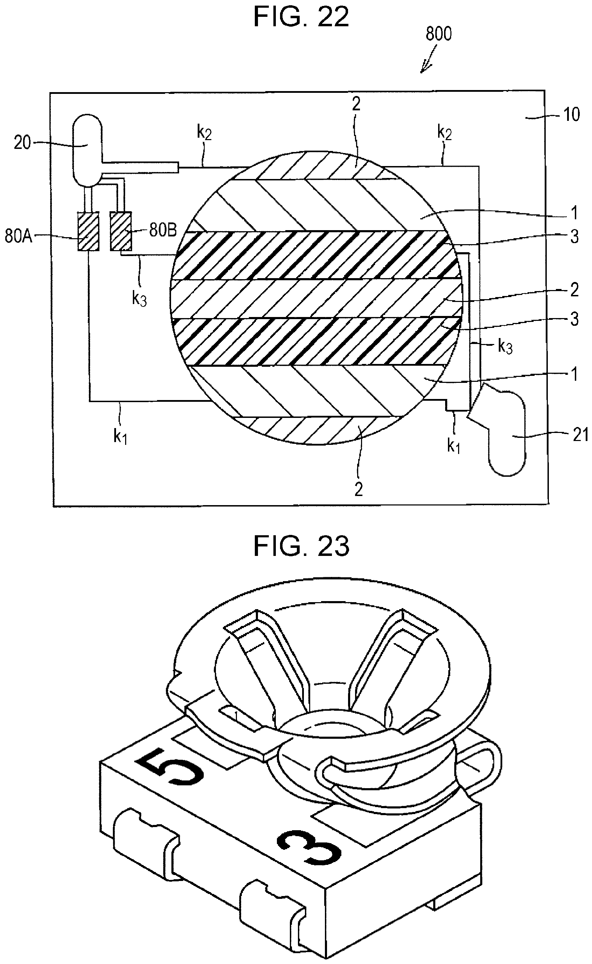

Fig. 22 is a plan view schematically showing a light-emitting device according to Embodiment 9 of the present invention.

The light-emitting device according to Embodiment 9 includes basic components that are identical to those which the light-emitting device according to Embodiment 1 includes. The light-emitting device according to Embodiment 9 differs from the light-emitting device according to Embodiment 1 in that the light-emitting device according to Embodiment 9 includes two first light-emitting units 1, three second light-emitting units 2, two third light-emitting units, three wiring patterns k1, k2, and k3, and a total of two resistors 80A and 80B connected to the wiring patterns k1 and k3, respectively.

Since the light-emitting device according to Embodiment 9 includes three types of light-emitting units and three types of wiring patterns, it has two points of inflection. The presence of two points of inflection makes it possible to divide an amount of change in color temperature into smaller amounts of change. This enables smooth color temperature regulation of the light-emitting device. Fig. 22 shows a case where the light-emitting device includes three types of light-emitting units and three types of wiring patterns. However, the numbers of types of light-emitting units and wiring patterns are not limited to 3, but may each be 4 or larger.

### [Embodiment 10]

The light-emitting device according to Embodiment 10 includes basic components that are identical to those which the light-emitting device according to Embodiment 1 includes. The light-emitting device according to Embodiment 11 differs from the light-emitting device according to Embodiment 1 in that the resistor is a variable resistor. Use of the variable resistor makes it possible to change the value of resistance even after assembling the light-emitting device, thus making it possible to control an electric current that is inputted to the light-emitting device. This makes it possible to reduce variations in color temperature among light-emitting devices. This further enables a user to adjust color temperature. The variable resistor is not limited to particular types. For example, as shown in Fig. 23, the variable resistor may be of a volume type.

### [Embodiment 11]

The light-emitting device according to Embodiment 11 includes basic components that are identical to those which the light-emitting device according to Embodiment 1 includes. The light-emitting device according to Embodiment 11 differs from the light-emitting device according to Embodiment 1 in that the resistor is a thermistor.

The thermistor is a temperature-sensitive resistor whose value of resistance changes according to a change in temperature of the surrounding atmosphere. The thermistor is a PTC-type (PTC: positive temperature coefficient) thermistor whose value of resistance logarithmically rises at a temperature higher than a certain temperature (Curie point) or an NTC-type (NTC: negative temperature coefficient) thermistor whose value of resistance logarithmically decreases from low temperature to high temperature. A change in the electric current that is inputted to the light-emitting device leads to a change in amount of heat that is generated by the light-emitting unit and, by extension, to a change in substrate temperature. Therefore, in a case where the resistor is a thermistor, the value of resistance of the thermistor is changed by changing the electric current that is inputted and thereby changing the temperature of the atmosphere surrounding the thermistor. This makes it possible to, by changing the electric current that is inputted, control the color temperature of light that is emitted by the whole light-emitting device. It should be noted that, in Embodiment 11, it is preferable that the thermistor be of an NTC type, as the value of resistance of an NTC-type thermistor slowly changes in response to temperature change.

### [Recapitulation of Embodiments]

A light-emitting device 6 according to an embodiment of the present invention as shown in Figs. 1 and 2 includes an anode electrode land 21, a cathode electrode land 20, and first and second wires k1 and k2 through which the anode electrode land 21 and the cathode electrode land 20 are connected to each other. The first wire k1 is higher in electric resistance than the second wire k2. The color temperature of light that is emitted by a whole light-emitting unit 12 including a first light-emitting unit 1 electrically connected to the first wire k1 and a second light-emitting unit 2 electrically connected to the second wire k2 is adjustable. The light-emitting device according to the present embodiment is capable of adjusting color temperature through the supply of electric power from a single power supply.

In the light-emitting device 6, it is preferable that each of the first and second light-emitting units 1 and 2 include an LED element 30, translucent resin, and at least two types of phosphors. The light-emitting device according to the present embodiment, which uses the LED elements as a light source, has a long life-span and generates less heat while it is on. Furthermore, since the light-emitting unit includes at least two types of phosphors, the color temperature of light that is emitted by the light-emitting unit can be adjusted by changing the types of phosphors and the amounts of the phosphors that are blended. Further, the phosphors contained in the light-emitting unit can efficiently absorb light that is emitted from the LED element and can thus improve light emission efficiency.

In the light-emitting device 6, it is preferable that the first wire k1 include a resistor 80. The light-emitting device according to the present embodiment makes it possible to, by adjusting the value of resistance of the first wire k1, adjust the color temperature of light that is emitted by the light-emitting unit 12.

In the light-emitting device 6, it is preferable that the first and second light-emitting units 1 and 2 be arranged so that lights respectively emitted by the first and second light-emitting units are mixed together. The light-emitting device according to the present embodiment allows the lights emitted from the first and second light-emitting units 1 and 2 to be uniformly mixed together, thus allowing light to be emitted at a more uniform color temperature.

In the light-emitting device 6, it is preferable that the phosphors contained in the first light-emitting unit differ in content percentage from those contained in the second light-emitting unit. The light-emitting device according to the present embodiment allows the first and second light-emitting units 1 and 2 to emit lights at different color temperatures.

In a light-emitting device 600, it is preferable that the light-emitting device 600 include a plurality of the first light-emitting units 601 and a plurality of the second light-emitting units 602, that the plurality of first light-emitting units 601 be connected in series on the first wire k1, that the plurality of second light-emitting units 602 be connected in series on the second wire k2, and that each of the plurality of first and second light-emitting units include an LED element 630, translucent resin, and at least two types of phosphors. The light-emitting device according to the present embodiment makes it possible to adjust color temperature through the supply of electric power from a single power supply.

In the light-emitting device 6, it is preferable that the resistor 80 be a chip resistor or a printed resistor. The light-emitting device according to the present embodiment makes it easy to adjust a value of resistance.

In the light-emitting device 6, it is preferable that the resistor 80 be covered with phosphor-containing resin or colored resin. The light-emitting device 6 according to the present embodiment allows less light to be absorbed by the resistor 80.

In the light-emitting device 6, it is preferable that the first wire k1 include a resistance value monitor. The light-emitting device according to the present embodiment makes it possible to accurately measure a value of resistance and makes it easy to adjust the color temperature of light that is emitted by the light-emitting unit 12.

In the light-emitting device 6, it is preferable that a protection element be connected in parallel to at least either the first wire k1 or the second wire k2. The light-emitting device according to the present embodiment makes it possible to prevent a wiring circuit from being damaged at the time of overcurrent conduction.

In the light-emitting device 6, it is preferable that a resin dam be provided around the first and second light-emitting units 1 and 2. The light-emitting device according to the present embodiment makes it possible to retain the first and second light-emitting units 1 and 2, which include the translucent resin, in the area surrounded by the resin dam.

In the light-emitting device 6, it is preferable that the resistor 80 be disposed outside of the resin dam. The light-emitting device according to the present embodiment allows less light to be absorbed by the resistor 80.

In the light-emitting device 6, it is preferable that the resistor 80 be covered with the resin dam. The light-emitting device 6 according to the present embodiment allows less light to be absorbed by the resistor 80.

In the light-emitting device 6, it is preferable that at least part of the first wire k1 and at least part of the second wire k2 be covered with the resin dam. The light-emitting device according to the present embodiment allows less light to be absorbed by the wires. Furthermore, the wires can be protected from external stress.

The present invention is not limited to the description of the embodiments above, but may be altered within the scope of the claims. An embodiment based on a proper combination of technical means disclosed in different embodiments is encompassed in the technical scope of the present invention.

### EXAMPLE 1

In Example 1, a test was conducted using a light-emitting device that is identical in configuration to Embodiment 2.

The substrate used was a ceramic substrate. The resistor 80 was a chip resistor having a value of resistance of 60 Ω.

In the first and second light-emitting units 1 and 2, the first red phosphor 60 (CaAlSiN₃:Eu), the second red phosphor 61 ((Sr,Ca)AlSiN₃:Eu), the green phosphor 70 (Lu₃Al₅O₁₂:Ce), and the blue LED elements 30 (emission wavelength of 450 nm) were sealed with silicone resin. The blue LED elements 30 were electrically connected to the wiring patterns through the wires, and the wiring patterns were electrically connected to the electrode lands.

The light-emitting device of Example 1 was configured such that the color temperature of light that is emitted by the first light-emitting units 1 is 5000 K and the color temperature of light that is emitted by the second light-emitting units 2 is 2700 K. Next, a relationship between the magnitude of a total of forward currents flowing through the first and second wires (hereinafter also referred to as "total forward current") and the color temperature of light that is emitted by the light-emitting device was examined.

The color temperature of light that was emitted by the whole light-emitting device when a total forward current of 350 mA flowed was 4000 K, and the color temperature of light that was emitted by the whole light-emitting device when a total forward current of 50 mA flowed was 2700 K.

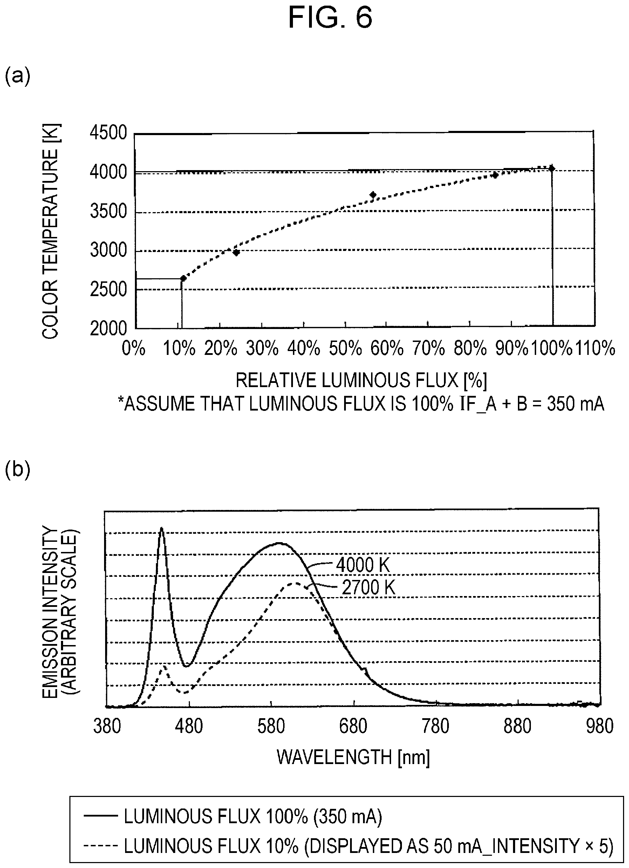

Fig. 6(a) is a graph showing a relationship between the relative luminous flux (%) and color temperature of light with varied total forward currents, assuming that the luminous flux of light that is emitted by the whole light-emitting unit at the time of a total forward current of 350 mA is 100%. Fig. 6(a) shows that a decrease in relative luminous flux leads to a drop in color temperature.

Fig. 6(b) is a diagram showing the spectra of lights that are emitted by the whole light-emitting device at color temperatures of 4000 K and 2700 K (total forward currents of 350 mA and 50 mA), respectively. Fig. 6(b) shows that the light-emitting device of Example 1 can change color temperature through the supply of electric power from a single power supply.

### EXAMPLE 2

In Example 2, a test was conducted using a light-emitting device that is identical in configuration to Embodiment 3.

The substrate used was a ceramic substrate. The resistors 280 and 281 were chip resistors each having a value of resistance of 125 Ω.

In the first and second light-emitting units 201 and 202, the first red phosphor 260 (CaAlSiN₃:Eu), the green phosphor 70 (Lu₃Al₅O₁₂:Ce), and the blue LED elements 230 (emission wavelength of 450 nm) were sealed with silicone resin. The blue LED elements were electrically connected to the wiring patterns through the wires, and the wiring patterns were electrically connected to the electrode lands.

The light-emitting device of Example 2 was configured such that the color temperature of light that is emitted by the first light-emitting units 201 is 4000 K and the color temperature of light that is emitted by the second light-emitting units 202 is 2000 K. Next, a relationship between the magnitude of a total of forward currents flowing through the first and second wires (hereinafter also referred to as "total forward current") and the color temperature of light that is emitted by the light-emitting device was examined.

The color temperature of light that was emitted by the whole light-emitting device when a total forward current of 350 mA flowed was 3000 K, and the color temperature of light that was emitted by the whole light-emitting device when a total forward current of 50 mA flowed was 2000 K.

### EXAMPLE 3

In Example 3, a test was conducted using a light-emitting device that is identical in configuration to Embodiment 4.

The substrate used was a ceramic substrate. The resistors 380 and 381 were printed resistors each having a value of resistance of 30 Ω.

In the first and second light-emitting units 301 and 302, the second red phosphor 361 ((Sr, Ca)AlSiN₃:Eu), the green phosphor 370 (Lu₃Al₅O₁₂:Ce), and the blue LED elements 330 (emission wavelength of 450 nm) were sealed with silicone resin. The blue LED elements were electrically connected to the wiring patterns through the wires, and the wiring patterns were electrically connected to the electrode lands.

The light-emitting device of Example 3 was configured such that the color temperature of light that is emitted by the first light-emitting units 301 is 3000 K and the color temperature of light that is emitted by the second light-emitting units 302 is 2000 K. Next, a relationship between the magnitude of a total of forward currents flowing through the first and second wires (hereinafter also referred to as "total forward current") and the color temperature of light that is emitted by the light-emitting device was examined.

The color temperature of light that was emitted by the whole light-emitting device when a total forward current of 350 mA flowed was 2700 K, and the color temperature of light that was emitted by the whole light-emitting device when a total forward current of 50 mA flowed was 2000 K.

### EXAMPLE 4

In Example 4, a test was conducted using a light-emitting device that is identical in configuration to Embodiment 5.

The substrate used was a ceramic substrate. The resistor 580 was a printed resistor having a value of resistance of 60 Ω.

In the first and second light-emitting units 501 and 502, the first red phosphor 560 (CaAlSiN₃:Eu), the second red phosphor 561 ((Sr,Ca)AlSiN₃:Eu), the green phosphor 570 (Lu₃Al₅O₁₂:Ce), and the blue LED elements 530 (emission wavelength of 450 nm) were sealed with silicone resin. The blue LED elements were electrically connected to the wiring patterns through the wires, and the wiring patterns were electrically connected to the electrode lands.

The light-emitting device of Example 4 was configured such that the color temperature of light that is emitted by the first light-emitting units 501 is 3000 K and the color temperature of light that is emitted by the second light-emitting units 502 is 2200 K. Next, a relationship between the magnitude of a total of forward currents flowing through the first and second wires (hereinafter also referred to as "total forward current") and the color temperature of light that is emitted by the light-emitting device was examined.

The color temperature of light that was emitted by the whole light-emitting device when a total forward current of 350 mA flowed was 2700 K, and the color temperature of light that was emitted by the whole light-emitting device when a total forward current of 50 mA flowed was 2200 K.

### EXAMPLE 5

In Example 5, a test was conducted using a light-emitting device that is identical in configuration to Embodiment 8. The light-emitting device is described below with reference to Fig. 21.

The substrate 310 used was a ceramic substrate. The resistors 380 and 381 were printed resistors. The wiring patterns 355, 351, 353, and 356 had values of resistance of 30 Ω, 31 Ω, 27.5 Ω, and 25 Ω, respectively.

In the first and second light-emitting units 301 and 302, the second red phosphor 361 ((Sr,Ca)AlSiN₃:Eu), the green phosphor 370 (Lu₃Al₅O₁₂:Ce), and the blue LED elements 330 (emission wavelength of 450 nm) were sealed with silicone resin. The blue LED elements were electrically connected to the wiring patterns through the wires.

### <Case of Wiring Patterns Having the Same Value of Resistance (30 Ω) >

Four types of light-emitting devices were fabricated. The blue LED elements of the four types of light-emitting devices had four different types of VF values (VF values: 3.04 V, 3.08 V, 3.17 V, and 3.27 V), respectively. In each of the light-emitting devices, the wires of the first light-emitting units were connected to the wiring pattern 355 (value of resistance 30 Ω).

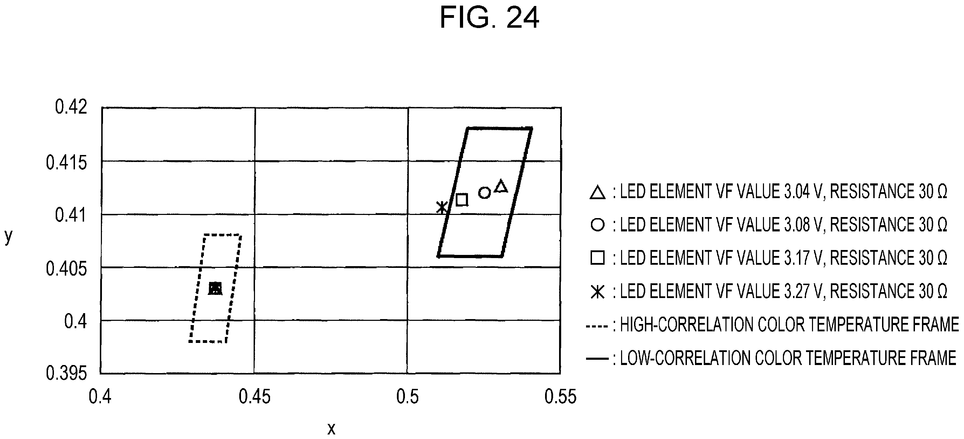

Forward currents of 100 mA to 700 mA were passed through the four types of light-emitting devices. Fig. 24 shows a chromaticity distribution of lights that are emitted by each separate light-emitting device as a whole in a low current range (100 mA) or a high current range (700 mA).

### <Case of Wiring Patterns Having Different Values of Resistance (30 Ω, 31 Ω, 27.5 Ω, and 25 Ω) >

Next, four types of light-emitting devices were fabricated with the four types of LED elements described above. The light-emitting devices had the following combinations of the VF value of the LED elements and the wiring pattern to which the wires of the first light-emitting units were connected:
<VF Values of LED Elements> <Wiring Patterns (Values of Resistance)>
3.04 V Wiring pattern 351 (31 Ω)
3.08 V Wiring pattern 355 (30 Ω)
3.17 V Wiring pattern 353 (27.5 Ω)
3.27 V Wiring pattern 356 (25 Ω)

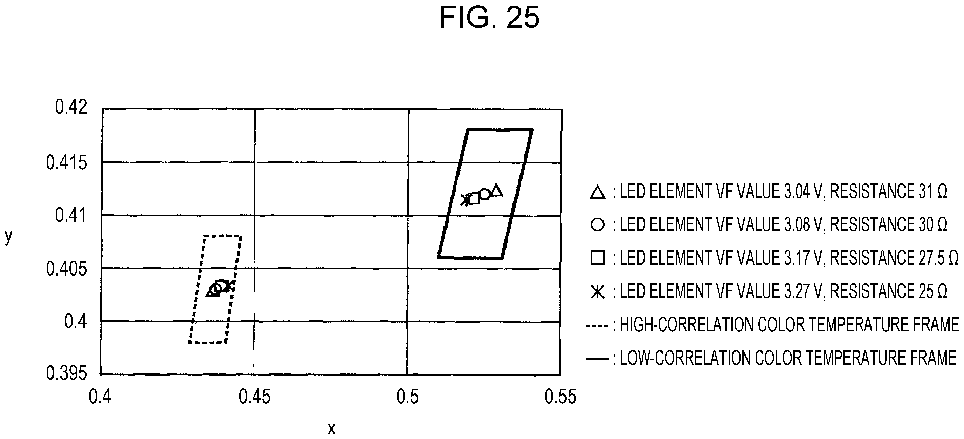

Forward currents of 100 mA to 700 mA were passed through the four types of light-emitting devices. Fig. 25 shows a chromaticity distribution of lights that are emitted by each separate light-emitting device as a whole in a low current range (100 mA) or a high current range (700 mA).

It should be understood that the embodiments and examples disclosed herein are illustrative and non-restrictive in every respect. The scope of the present invention is defined by the terms of the claims, rather than the description above, and is intended to include any modifications within the scope and meaning equivalent to the terms of the claims.

### Reference Signs List

1, 201, 301, 401, 501, 601, 701 First light-emitting unit
2, 202, 302, 402, 502, 602, 702 Second light-emitting unit
12, 612, 712 Light-emitting unit
14 Longitudinal end
6, 100, 200, 300, 400, 500, 600, 700, 800 Light-emitting device
10, 210, 310, 510, 610, 710 Substrate
20, 220, 320, 520, 620, 720 Cathode electrode land
21, 221, 321, 521, 621, 721 Anode electrode land
22 Resistance value monitoring land
30, 230, 330, 530, 630, 730 LED element
40, 240, 340, 440, 540 Resin dam
50, 51, 52, 251, 252, 350, 351, 353, 354, 450, 451, 453, 454, 550, 551, 552 Wiring pattern
60, 260, 560, 660, 760 First red phosphor
61, 361, 461, 561, 661, 761 Second red phosphor
70, 270, 370, 470, 570, 670, 770 Green phosphor
80, 280, 281, 380, 381, 580, 680, 780, 80A, 80B Resistor
90, 590 Wire
703 Reflector
k1 First wire
k2 Second wire
k3 Third wire

## Claims

1. A light-emitting device comprising:
an anode electrode land;
a cathode electrode land; and
first and second wires through which the anode electrode land and the cathode electrode land are connected to each other,
wherein the first wire is higher in electric resistance than the second wire, and
a color temperature of light that is emitted by a whole light-emitting unit including a first light-emitting unit electrically connected to the first wire and a second light-emitting unit electrically connected to the second wire is adjustable.

2. The light-emitting device according to Claim 1, wherein each of the first and second light-emitting units includes an LED element, translucent resin, and at least two types of phosphors.

3. The light-emitting device according to Claim 1, wherein the first wire includes a resistor.

4. The light-emitting device according to Claim 1, wherein the first and second light-emitting units are arranged so that lights respectively emitted by the first and second light-emitting units are mixed together.

5. The light-emitting device according to Claim 2, wherein the phosphors contained in the first light-emitting unit differ in content percentage from those contained in the second light-emitting unit.

6. The light-emitting device according to Claim 1, wherein the light-emitting device comprises a plurality of the first light-emitting units and a plurality of the second light-emitting units,
the plurality of first light-emitting units are connected in series on the first wire,
the plurality of second light-emitting units are connected in series on the second wire, and
each of the plurality of first and second light-emitting units includes an LED element, translucent resin, and at least two types of phosphors.

7. A light-emitting device comprising:
a substrate;
an anode electrode land;
a cathode electrode land; and
first and second wires through which the anode electrode land and the cathode electrode land are connected to each other, the anode electrode land, the cathode electrode land, and the first and second wires being disposed on the substrate,
wherein the first wire is higher in electric resistance than the second wire,
a color temperature of light that is emitted by a whole light-emitting unit including a first light-emitting unit electrically connected to the first wire and a second light-emitting unit electrically connected to the second wire is adjustable,
the light-emitting device further comprises, on the substrate, a resin dam surrounding the whole light-emitting unit including the first and second light-emitting units, and
either the first light-emitting unit or the second light-emitting unit covers at least part of the resin dam.

8. The light-emitting device according to Claim 7, wherein the light-emitting unit that covers the at least part of the resin dam is greater in height than the other light-emitting element.
